# FASCICULE DE BREVET EUROPEEN

(11) **EP 2 186 706 B1**
(45) Date de publication et mention de la délivrance du brevet: **18.04.2012**
(21) Numéro de dépôt: 09175281.6
(22) Date de dépôt: 06.11.2009
(51) Int. Cl.: B61L 3/12, G01R 31/02, G01R 31/08

(54) **Dispositif de détection d'anomalie pour une installation de supervision d'un véhicule ferroviaire, installation et procédé associés**
Vorrichtung zum Erkennen von Anomalien für eine Überwachungsanlage eines Schienenfahrzeugs sowie entsprechende Anlage und entsprechendes Verfahren
Device for detecting anomalies in an installation for rail vehicle supervision, associated installation and method

(30) Priorité: 12.11.2008 FR 0857661
(43) Date de publication de la demande: 19.05.2010
(73) Titulaire: ALSTOM Transport SA, 92300 Levallois-Perret (FR)
(72) Inventeur: Lauger, Rémi, 69300 Caluire (FR); Orion, Jacques, 38200 Vienne (FR)
(74) Mandataire: Blot, Philippe Robert Emile

(56) Documents cités:
- EP-A1- 1 661 784
- WO-A1-01/13132
- DE-A1- 4 038 267
- DE-A1- 19 708 518
- US-B1- 6 980 007
- RHEIN D ET AL: "ETCS Level 1 Lineside System - The Alcatel Solution" SIGNAL + DRAHT, TELZLAFF VERLAG GMBH. DARMSTADT, DE, vol. 94, 1 septembre 2002 (2002-09-01), pages 58-65, XP002276768 ISSN: 0037-4997

## Description

La présente invention a pour domaine celui des dispositifs de détection d'anomalie pour un équipement au sol d'une installation de supervision d'un véhicule ferroviaire, tel qu'un train ou un métro.

Différents acteurs du monde ferroviaire européen ont défini la norme ERTMS/ETCS (dans ses spécifications 036 et 085), acronyme de l'expression anglaise « European Rail Traffic Management / European Train Control System » pour le développement d'un système de contrôle de train. L'ERTMS/ETCS a pour but de superviser la conduite d'un train tout au long de son parcours. Pour cela le train reçoit des informations sur la signalisation et/ou sur la topologie du tronçon de voie sur lequel il s'engage, dans le but de pouvoir optimiser, à chaque instant, sa vitesse. La régulation de la vitesse du train se fait automatiquement en supervisant les actions du conducteur et en se substituant à lui dans certaines situations.

Pour la mise en oeuvre de ces principes, la norme ERTMS/ETCS prévoit un équipement embarqué à bord du train et des équipements au sol.

Un équipement embarqué comporte une antenne apte à recevoir des signaux radio de courte portée, émis par un équipement au sol, et une unité de calcul et de commande connectée à l'antenne, apte à traiter le signal radio reçu et à actionner de manière adaptée différents organes du train, et, en particulier, son système de freinage.

Un équipement au sol comporte un encodeur ou LEU, acronyme anglais du mot « Line Side Electronic Unit » pour « unité électronique latérale », apte à être commandé depuis une station de contrôle distante, et au moins une balise disposée sur la voie, par exemple au droit d'un équipement de signalisation ou au début d'un tronçon de voie, et reliée à une sortie du LEU au moyen d'un câble de communication. Un LEU particulier peut être connecté jusqu'à quatre balises par quatre câbles de communication.

Un LEU particulier est programmé avec les paramètres topologiques du tronçon de voie qu'une balise à laquelle il est relié doit équiper. Ces paramètres topologiques comportent, par exemple, la pente du tronçon de voie, l'existence d'un virage, une vitesse maximale de sécurité, etc. Il est apte à générer un télégramme comportant ces paramètres topologiques et à le transmettre à la balise correspondante selon un protocole défini dans la norme ERTMS/ETCS. La balise connectée au LEU émet un signal radio comportant le télégramme reçu.

Le câble de communication entre le LEU et une balise peut atteindre 5000 m. Un tel câble est placé à proximité de la voie, souvent enterré dans une goulotte fermée courant le long de la voie. Le fonctionnement correct du câble de communication peut être altéré par une mauvaise installation, des variations thermiques importantes, des vibrations lors du passage d'un train, un accident lorsque, par exemple, des ouvriers travaillent sur la voie, une malveillance, un raccordement incorrect de deux segments du câble, etc.

Le document EP 1 661 784 A1 divulgue un procédé de contrôle consistant à comparer des valeurs d'arrivée d'une donnée, transmises par deux voies différentes.

L'invention a donc pour but de proposer un dispositif permettant de détecter une anomalie le long d'un câble de communication reliant un LEU et une balise, et en particulier une anomalie du type circuit ouvert ou court-circuit.

L'invention porte sur un dispositif de détection d'anomalie le long d'un câble de communication reliant un encodeur et une balise d'un équipement au sol d'une installation de supervision d'un véhicule ferroviaire, comportant : des moyens de mesure de l'impédance aptes à mesurer, à une fréquence prédéterminée, la phase et le module de l'impédance du câble lors de la transmission d'un signal électrique de communication généré par l'encodeur à destination de la balise ; et des moyens de détermination de l'état du câble aptes à comparer la phase et le module mesurés à des valeurs de référence de la phase et du module de l'impédance du câble de manière à déterminer un état du câble parmi un état de fonctionnement normal, un état en court circuit et un état en circuit ouvert.

Suivant des modes particuliers de l'invention, le dispositif comporte une ou plusieurs des caractéristiques suivantes, prise(s) isolément en suivant toutes les combinaisons techniquement possibles :
- les moyens de mesure de l'impédance sont aptes à mesurer une valeur instantanée de la phase et du module de l'impédance du câble, et les moyens de détermination de l'état du câble sont aptes à déterminer d'un état instantané du câble, pour détecter en temps réel la survenue d'une anomalie.
- les moyens de mesure de l'impédance comportent des moyens de mesure de la tension et des moyens de mesure de l'intensité en un point de câble ; et des moyens de filtrage aptes à filtrer, à la fréquence prédéterminée, les signaux de mesure de la tension et de l'intensité respectivement délivrées par les moyens de mesure de la tension et de l'intensité pour produire des signaux filtrés de mesure de la tension et de l'intensité.

- le moyen de mesure de la tension comporte un transformateur d'isolation à impédance élevée dont le primaire est connecté en série en entrée du câble, et le moyen de mesure de l'intensité comporte un transformateur de courant à résistance faible dont le primaire est connecté en série en entrée du câble.
- la fréquence prédéterminée correspond à la fréquence du signal « C6 » d'un signal électrique de communication entre l'encodeur et la balise selon la norme ERTMS/ETCS.
- lesdites valeurs de référence de la phase et du module de l'impédance du câble délimitent des domaines dans le plan complexe de l'impédance du câble de manière à définir une cartographie de calibration, et les moyens de détermination de l'état du câble sont aptes à situer la phase et le module mesurés dans un domaine particulier de la cartographie et à affecter à l'état du câble un état associé au domaine particulier.
- lorsque les moyens de détermination de l'état du câble déterminent un état du câble parmi un état en court circuit et un état en circuit ouvert, les moyens de détermination sont aptes à calculer la position le long du câble de l'anomalie associée.
- la cartographie de calibration comporte une courbe associée à un état du câble parmi un état en court circuit et un état en circuit ouvert, une position sur la courbe indiquant la position le long du câble de l'anomalie associée, et les moyens de détermination de l'état du câble sont aptes à positionner la phase et le module mesurés sur la courbe lors de la détection d'une anomalie et à calculer la position le long du câble de l'anomalie.
- le dispositif comporte un moyen de déconnexion électrique permettant de court-circuiter la sortie de l'encodeur à laquelle est relié le câble de communication en réponse à la détermination que le câble est dans un état parmi un état en court circuit et un état en circuit ouvert.
- le dispositif comporte des moyens d'affichage de l'état du câble.
- le dispositif comporte des moyens de mémorisation aptes à stocker des données relatives aux états successifs du câble, et une interface d'entrée/sortie permettant la communication avec un terminal utilisateur pour le transfert des données.

L'invention porte sur équipement au sol d'une installation de supervision d'un véhicule ferroviaire, comportant un encodeur, une balise disposée sur la voie et un câble de communication reliant l'encodeur et la balise. L'équipement comporte un dispositif de détection d'anomalie tel que celui qui a été présenté ci-dessus.

De préférence, le dispositif de détection d'anomalie est disposé à l'interface entre l'encodeur et le câble de communication.

L'invention porte également sur un procédé de détection d'une anomalie du type court-circuit ou circuit ouvert le long d'un câble de communication reliant un encodeur et une balise d'un équipement au sol d'une installation de supervision d'un véhicule ferroviaire, mettant en oeuvre un dispositif de détection d'anomalie tel que celui qui a été décrit ci-dessus. Le procédé comporte les étapes consistant à mesurer, à une fréquence prédéterminée, la phase et le module de l'impédance du câble lors de la transmission d'un signal électrique de communication généré par l'encodeur à destination de la balise ; et à comparer la phase et le module mesurés à des valeurs de référence de la phase et du module de l'impédance du câble de manière à déterminer un état du câble parmi un état de fonctionnement normal, un état en court circuit et un état en circuit ouvert.

De préférence, après avoir déterminé que le câble est dans un état en court-circuit ou en circuit ouvert, le procédé comporte une étape consistant à calculer la position de l'anomalie le long du câble.

L'invention et ses avantages seront mieux compris à la lecture de la description qui va suivre, donnée uniquement à titre d'exemple et faite en se référant aux dessins annexés, sur lesquels :
- la figure 1 est une représentation sous la forme d'un schéma blocs du dispositif de détection selon l'invention ;
- la figure 2 est un schéma électronique d'un moyen du dispositif de la figure 1 permettant de mesurer la tension appliquée en entrée du câble ;
- la figure 3 est un schéma électronique d'un moyen du dispositif de la figure 1 permettant de mesurer l'intensité appliquée en entrée du câble ;
- la figure 4 est une cartographie délimitant, dans le plan complexe de l'impédance du câble de communication, différents domaines, chaque domaine correspondant à un état du câble ; et,
- la figure 5 est un schéma électronique d'un moyen du dispositif de la figure 1 permettant de déconnecter le câble du LEU en réponse à la détection d'une anomalie.

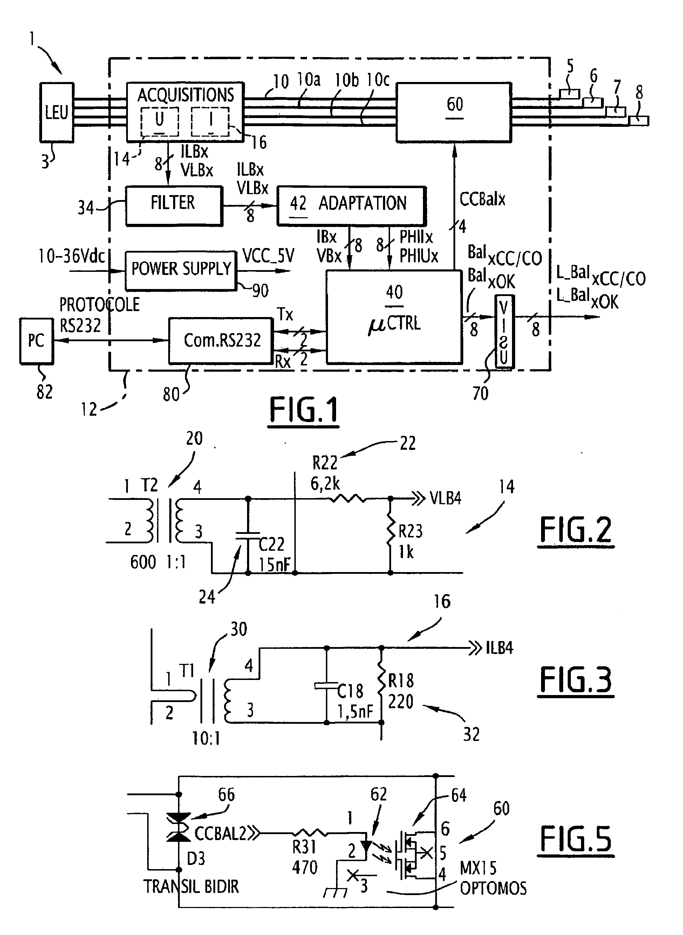

L'équipement au sol 1 d'une installation respectant la norme ERTMS/ETCS pour la supervision d'un train circulant le long d'une voie, comporte un encodeur ou LEU 3, au moins une balise 5 disposée entre les deux rails de la voie, et un câble de communication 10 reliant le LEU 3 et la balise 5. Sur la figure 1, comme cela est généralement le cas, un même LEU 3 est relié à quatre balises 5 à 8 par autant de câbles de communication 10, 10a, 10b et 10c..

Le câble 10 permet la communication descendante du LEU 3 vers la balise 5.

La norme ERTMS/ETCS définit à la fois un protocole de communication au niveau de la couche physique et un protocole de communication au niveau de la couche d'échange de données. Le protocole de communication au niveau de la couche physique est plus particulièrement défini dans les spécifications 036 et 085 de la norme ERTMS/ETCS.

On notera que certaines installations de supervision d'un véhicule ferroviaire utilisent le protocole de communication au niveau de la couche physique défini par la norme ERTMS/ETCS, sans pour autant mettre en oeuvre le protocole d'échange de données selon cette même norme. Elles adoptent un autre protocole d'échange de données. C'est en particulier le cas des installations de supervision d'un métro pour lesquelles les protocoles ne sont pas encore figés dans des normes. Ainsi, l'homme du métier comprendra que ce que est décrit ci-après relativement à la couche physique de la norme ERTMS/ETCS pour la supervision d'un train trouve également une application dans des installations analogues.

Selon la norme ERTMS/ETCS, en communication descendante, le LEU 3 génère les signaux électriques suivants :
- un signal dit « C1 » correspondant à la transmission, en permanence, de télégrammes de données. Le signal C1 a une fréquence F1 de 654 kbits/s et il est émis en mode différentiel bi-phase Manchester ; et,
- un signal dit « C6 » d'alimentation en puissance électrique de la balise 5. Le signal C6 est un signal sinusoïdal ayant une amplitude de 22 V et une fréquence F6 de 8,82 kHz.

L'équipement au sol 1 comporte également un dispositif de détection 12 apte à détecter, en temps réel, la présence et la position d'une anomalie le long du câble de communication 10. Le dispositif de détection 12 mesure l'impédance du câble 10 alors qu'il est couplé à la balise 5, puis détecte une anomalie en fonction de l'impédance mesurée. Une telle anomalie est du type court-circuit ou circuit ouvert.

Dans le mode de réalisation actuellement envisagé représenté à la figure 1, le dispositif 12 prend la forme d'une carte électronique. Le dispositif de détection 12 est disposé en tant qu'interface entre le LEU 3, d'une part, et le câble de communication 10 et la balise 5, d'autre part. L'entrée du dispositif 12 est connectée en sortie du LEU 3 et l'entrée du câble 10 est connectée en sortie du dispositif 12. Pour que le dispositif 12 puisse fonctionner avec des LEU fabriqués par des constructeurs différents, l'entrée du dispositif 12 reprend la connectique d'un câble de communication telle que définie dans la norme ERTMS/ETCS, et la sortie du dispositif 12 reprend la connectique de sortie d'un LEU, telle que spécifiée par la norme ERTMS/ETCS.

Le dispositif 12 comporte des moyens de mesure de l'impédance et des moyens de détermination de l'état du câble à partir de la mesure de l'impédance réalisée par les moyens de mesure de l'impédance.

Le dispositif 12 est apte à mesurer l'impédance du câble 10, non pas par réflectométrie d'un signal électrique impulsionnel appliqué en entrée du câble, mais à partir des signaux électrique de communication appliqués par le LEU 3 en entrée du câble 10 au cours du fonctionnement normal de l'équipement 1. Ainsi, la mesure de l'impédance est totalement transparente vis-à-vis de la communication entre le LEU 3 et la balise 5, la mesure n'ayant quasiment aucun impact sur les caractéristiques de la liaison entre le LEU 3 et la balise 5.

Les moyens de mesure de l'impédance sont aptes à mesurer l'impédance instantanée du câble 10 lorsqu'un signal électrique, correspondant à la superposition des signaux C1 et C6, parcourt le câble 10. Pour cela, les moyens de mesure de l'impédance mesurent, à chaque instant, à la fréquence F6, la phase et l'amplitude de l'impédance du câble 10.

Plus précisément, les moyens de mesure de l'impédance comportent des moyens de mesure de la tension 14 et des moyens de mesure de l'intensité 16. Pour mesurer la tension du courant circulant dans le câble 10 (figure 2), un transformateur d'isolation 20 à haute impédance est utilisé. La mesure de la tension n'affecte pas le signal émis par le LEU 3 le long du câble 10 à condition de choisir la résistance de charge 22, placée au secondaire du transformateur d'isolation 20, de manière à ce qu'elle soit très élevée. Le transformateur d'isolation 20 a un rapport de 1 au primaire pour 1 au secondaire. Avantageusement, en plaçant un condensateur 24 au secondaire du transformateur d'isolation, le signal de mesure de la tension en sortie du moyen 16 a subit un premier filtrage. Le signal de mesure de la tension a un niveau de 5 Vppmax en sortie du moyen de mesure de la tension 14.

Pour mesurer l'intensité du courant circulant dans le câble 10 (figure 3), un transformateur d'intensité 30 à faible impédance d'entrée est utilisé. Le primaire de ce transformateur d'intensité 30 est constitué par le câble 10. Le transformateur d'intensité 30 a un rapport de 1 au primaire pour 10 au secondaire. Il possède une résistance d'entrée équivalente de 65 mΩ. Il est vu depuis le LEU 3 comme une simple augmentation de la longueur du câble 10 de quelques mètres, ce qui ne gène en rien la communication entre le LEU 3 et la balise 5. En plaçant une résistance 32 d'environ 200 Ω au secondaire du transformateur d'intensité 30, on obtient en sortie du moyen 30 un signal de mesure de l'intensité qui est un signal en tension dont l'amplitude vaut par exemple 20 mV par mA au primaire lorsque l'on prend les valeurs numériques des composants électroniques indiquées sur la figure 3.

On souhaite mesurer l'impédance du câble 10 pour une fréquence prédéterminée correspondant à la fréquence F6 du signal C6 tel que défini dans la norme ERTMS/ETCS. Le signal C6 à une fréquence F6 de 8,82 kHz avec une tension crête à crête minimale sensiblement égale à 19 Vppmin.

Les moyens de mesure de l'impédance comportent donc des moyens de filtrage 34 aptes à filtrer les signaux de mesure de la tension et de l'intensité de manière à rejeter les composantes perturbant la composante associée au signal C6, et en particulier la composante associée au signal C1. Le signal C1 ayant un spectre en puissance s'étalant entre ½.F1 et 2. F1, la fréquence de coupure des moyens de filtrage 34 doit être choisie inférieure à ½.F1, c'est-à-dire inférieure à 282 kHz. Cette fréquence de coupure est choisie trois octaves au-dessous de la fréquence ½.F1 pour rejeter au mieux la composante associée au signal C1. Ainsi la fréquence de coupure des moyens 34 vaut 35 kHz.

Le filtrage du signal de mesure de la tension fait intervenir un premier étage de filtrage au niveau du transformateur d'isolation 20 comme mentionné ci-dessus. Puis, le signal de mesure de la tension passe à travers un second étage de filtrage comportant un filtre du second ordre pour produire un signal filtré de mesure de la tension.

Le filtrage du signal de mesure de l'intensité est réalisé par deux filtres du second ordre placés en série l'un de l'autre. Le premier filtre ramène le signal de la mesure de l'intensité à un niveau de 5 Vppmax et le second filtre est équivalent au second étage des moyens de filtrage du signal de mesure de la tension. Un signal filtré de mesure de l'intensité est produit en sortie des moyens 34.

Les signaux de mesure filtrés sont appliqués en entrée d'un microcontrôleur 40 via un moyen d'adaptation 42 qui sera décrit ci-après. Le microcontrôleur 40 calcule le module et la phase de l'impédance du câble 10.

Le rapport de la valeur maximale du signal filtré de mesure de la tension sur la valeur maximale du signal filtré de mesure de l'intensité permet de déterminer le module de l'impédance du câble de communication 10.

La comparaison du décalage temporel entre les signaux filtrés de mesure de la tension et de l'intensité permettent de mesurer la phase de l'impédance du câble de communication 10. Plus précisément, chaque entrée du microcontrôleur est associée à un compteur de cycles d'horloge. Lorsque le signal filtré de mesure de la tension s'annule, le compteur de tension associé est réinitialisé. Puis, au moment où le signal filtré de mesure de l'intensité s'annule, ce qui réinitialise un compteur d'intensité, la valeur du compteur de tension donne une mesure du déphasage entre les deux signaux de mesure et, par conséquent, de la phase de l'impédance du câble 10.

Pour améliorer encore la sensibilité des moyens de mesure de l'impédance au passage à la valeur nulle des signaux filtrés de mesure de la tension et de l'intensité, ceux-ci sont amplifiés par les moyens d'adaptation 42. De préférence, ils sont amplifiés jusqu'à la saturation pour obtenir des signaux présentant des pentes raides. Cette étape d'adaptation est réalisée par passage des signaux filtrés de mesure dans des comparateurs. Les sorties de ces comparateurs sont appliquées à différentes entrées du microcontrôleur 40.

Les mesures du module et de la phase de l'impédance sont moyennées sur plusieurs périodes successives pour obtenir une mesure plus précise de l'impédance complexe. Cela permet de s'affranchir des variations brutales mais réversibles de l'impédance du câble 10 et de la balise 5, par exemple lors du passage d'un train au-dessus de la balise 5. En effet, lors du passage d'un train au-dessus de la balise 5, l'impédance chute, mais pendant un temps très court de 150 à 350 µs. Le dispositif 12 détectera cette variation d'impédance, mais ne la prendra pas en considération dans la détermination de l'état du câble 10 car elle ne dure pas suffisamment longtemps.

Les moyens permettant de déterminer l'état du câble vont maintenant être décrits.

Le microcontrôleur 40 comporte une mémoire morte dans laquelle est stockée une cartographie de calibration 50 délimitant différents domaines dans le plan complexe des valeurs de l'impédance du câble 10.

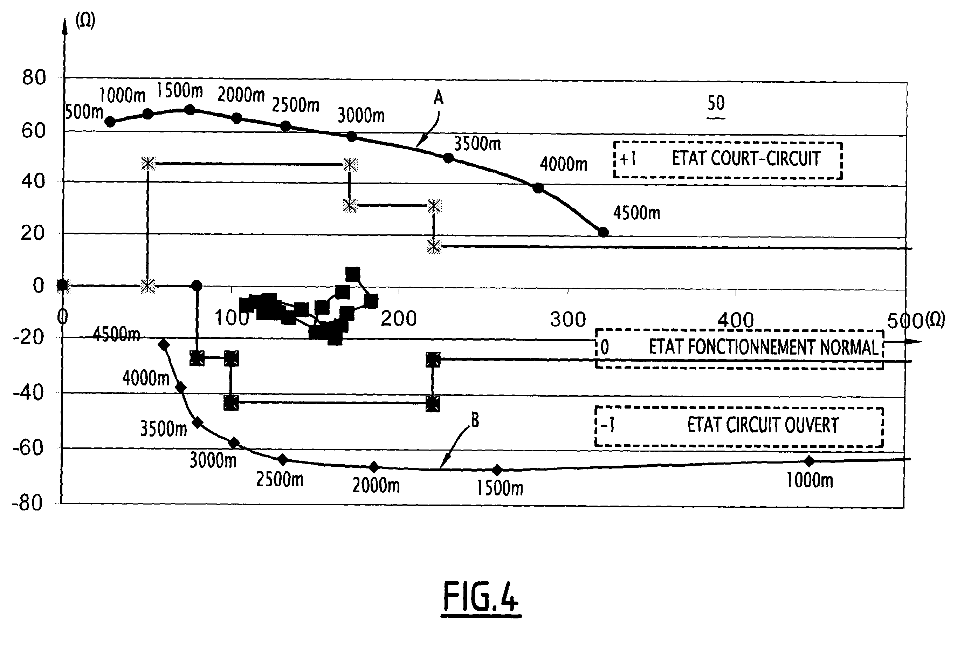

Une telle cartographie 50 est représentée à la figure 4. Elle est obtenue à l'issue d'une étape de calibration d'un câble de communication de référence du même type que le câble 10.

Lors de cette calibration, on mesure la valeur de l'impédance du câble de référence placé dans un état de fonctionnement normal. La valeur de l'impédance mesurée est reportée sur la cartographie 50.

Puis, on mesure la valeur de l'impédance du câble de référence placé dans un état de court-circuit. La valeur de l'impédance est mesurée pour différentes positions du court-circuit le long du câble de référence, par exemple des positions écartées les unes des autres d'un pas de 500 m. La succession des valeurs de l'impédance ainsi mesurées sont reportées sur la cartographie 50. Une courbe A est obtenue par extrapolation d'une courbe passant par les différents points de calibration en court-circuit.

De manière similaire, on mesure la valeur de l'impédance du câble de référence placé dans un état de circuit ouvert. La valeur de l'impédance est mesurée pour différentes positions du circuit ouvert le long du câble de référence, par exemple pour des positions écartées les unes des autres d'un pas de 500 m. La succession des valeurs de l'impédance en circuit ouvert sont reportées sur la cartographie 50. Une courbe B est obtenue par extrapolation d'une courbe passant par les différents points de calibration en circuit ouvert.

On notera que les courbes A et B ne se recoupent pas. Elles sont distantes l'une de l'autre, ainsi que des valeurs de l'impédance du câble connecté à la balise, dans l'état en fonctionnement normal.

A partir de ces points de calibration de différents types, on subdivise le plan complexe en différents domaines. Chaque domaine correspond à un état du câble : état de fonctionnement normal, état de court-circuit et état de circuit ouvert.

De plus, la position d'une valeur de l'impédance sur la courbe A, ou la courbe B, permet de déterminer la position de l'anomalie associée le long du câble.

En fonctionnement, le microcontrôleur 40, par comparaison avec la cartographie 50, affecte à l'impédance mesurée un domaine particulier et associé à l'état instantané du câble l'état correspondant à ce domaine. Dans la pratique, le microcontrôleur 40 affecte à un paramètre d'état daté la valeur +1 lorsque l'état du câble est en court-circuit, la valeur 0 lorsque l'état du câble est en fonctionnement, et la valeur -1 lorsque l'état du câble est en circuit ouvert.

De manière avantageuse, lorsqu'une anomalie est détectée, le microcontrôleur 40 détermine la position de l'anomalie le long du câble. Pour cela, il place la valeur de l'impédance mesurée sur la courbe A, ou la courbe B, et, par exemple par une méthode barycentrique entre les points de calibration les plus proches, calcule la position de l'anomalie le long du câble 10. La position peut être calculée avec une assez bonne précision, de l'ordre de 250 m. La position calculée de l'anomalie est sauvegardée dans un paramètre de distance associé au paramètre d'état.

Le dispositif 12 comporte également un moyen de déconnexion électrique 60. En se référant à la figure 5, le moyen de déconnexion 60 comporte une LED 62 connectée à une borne de sortie du microcontrôleur 40 et commandée par la valeur du paramètre d'état. En réponse à une valeur du paramètre d'état différente de la valeur nulle, la LED 62 ferme un commutateur à MOSFETs 64 conduisant à la mise en court-circuit de la sortie correspondante du LEU 3. Le LEU 3 étant protégé contre la mise en court-circuit d'une de ses sorties, il arrête la transmission du signal électrique de communication sur la sortie court-circuitée et émet simultanément un rapport en direction de la station de contrôle distante indiquant la rupture de la liaison avec la balise connectée à la sortie considérée. Parallèlement, la balise 5 n'étant plus connectée au LEU 3 elle émet un signal radio comportant un télégramme par défaut définit dans la norme ERTMS/ETCS. Un train passant au-dessus de la balise et recevant un tel télégramme par défaut aura sa vitesse optimisée réduite.

De préférence, en parallèle au commutateur MOSFETs 64, le moyen de déconnexion 60 comporte un suppresseur de surtension 66 de manière à protéger le LEU 3 d'éventuelles surtensions.

Le dispositif 12 comporte également des moyens d'affichage 70 permettant d'afficher, entre autre, l'état des différents câbles 10, 10a, 10b et 10c. Il s'agit par exemple d'un tableau composé d'une rangée de quatre LEDs vertes et d'une rangée de quatre LEDs rouges. Les états des différentes LED permettent à l'opérateur de connaître l'état des quatre câbles 10, 10a,10b 10c selon le tableau I suivant :

**(Tableau I)**

| **Etat** | **LED rouges** | **LED vertes** |
|---|---|---|
| Pas d'alimentation électrique | Toutes éteintes | Toutes éteintes |
| i^{ème} Balise connectée | i^{ème} LED allumée | i^{ème} LED allumée |
| Circuit ouvert sur le i^{ème} câble | i^{ème} LED allumée | i^{ème} LED éteinte |
| Court-circuit sur le i^{ème} câble | i^{ème} LED éteinte | i^{ème} LED allumée |
| i^{ème} entrée n'est pas connectée au LEU | i^{ème} LED clignote | i^{ème} LED clignote en phase |
| i^{ème} sortie du LEU inhibée | i^{ème} LED clignote | i^{ème} LED Clignote en opposition de phase |
| i^{ème} sortie du dispositif de détection inhibée | i^{ème} LED clignote rapidement | i^{ème} LED clignote rapidement |

L'homme du métier sait comment utiliser les valeurs mesurées du courant et de la tension pour déterminer les autres états possibles indiqués dans le tableau I.

Par ailleurs, le microcontrôleur 40 est apte à mémoriser des données correspondant aux états du câble 10 et aux paramètres de distance associée à chaque fois qu'une d'anomalie a été détectée. Le dispositif 12 comporte une interface d'entrée/sortie 80, par exemple du type RS232, permettant la communication entre un terminal utilisateur 82 et le microcontrôleur 40 de manière à transférer les données sous forme d'un historique en vue d'une analyse hors ligne ou en temps réel pour une gestion à distance des alarmes. L'analyse logicielle en temps réel de ces données permet éventuellement de se dispenser du moyen de déconnexion électrique 60.

Enfin, le dispositif 12 comporte une alimentation électrique 90 permettant d'alimenter la carte électronique avec une tension continue de 5 V.

A la lecture de la description de la figure 1 de dispositif qui a été faite en termes de fonctions, l'homme du métier saura comment s'enchaînent les étapes d'un procédé de détection d'une anomalie du type court-circuit ou circuit ouvert le long du câble 10 reliant l'encodeur 3 à une balise 5 mettant en oeuvre le dispositif de détection d'anomalie 12.

L'homme du métier constatera que le présent dispositif de détection d'anomalie permet la détection d'une anomalie, quasiment au moment où elle survient, en précise la nature et en donne une localisation le long du câble affecté. Ainsi, les effets de cette anomalie sur le trafic des trains le long de la voie peuvent être immédiatement pris en compte et une équipe peut rapidement intervenir sur le site indiqué pour rétablir le fonctionnement normal de la liaison encodeur / balise.

Un tel dispositif peut également être utilisé lors du déploiement de l'installation ERTMS/ETCS et plus particulièrement dans la phase de test de cette installation.

Enfin, un tel dispositif peut trouver des applications non seulement dans le niveau 1 de la norme ETCS, mais également dans le niveau 2 de cette norme alors que les balises disposées sur la voie ne sont utilisées qu'en tant que moyens de secours en cas de rupture de la communication GPS.

## Revendications

1. Dispositif de détection d'anomalie (12) le long d'un câble de communication (10, 10a, 10b, 10c) reliant un encodeur (3) et une balise (5) d'un équipement au sol d'une installation de supervision d'un véhicule ferroviaire, **caractérisé en ce qu'**il comporte :
- des moyens de mesure de l'impédance (14, 16, 34, 42) aptes à mesurer, à une fréquence prédéterminée, la phase et le module de l'impédance du câble (10) lors de la transmission d'un signal électrique de communication généré par l'encodeur à destination de la balise ; et,
- des moyens de détermination de l'état du câble aptes à comparer la phase et le module mesurés à des valeurs de référence de la phase et du module de l'impédance du câble de manière à déterminer un état du câble parmi un état de fonctionnement normal, un état en court circuit et un état en circuit ouvert.

2. Dispositif selon la revendication 1, **caractérisée en ce que** les moyens de mesure de l'impédance sont aptes à mesurer une valeur instantanée de la phase et du module de l'impédance du câble (10), et **en ce que** les moyens de détermination de l'état du câble sont aptes à déterminer d'un état instantané du câble, pour détecter en temps réel la survenue d'une anomalie.

3. Dispositif selon la revendication 1 ou la revendication 2, **caractérisé en ce que** les moyens de mesure de l'impédance comportent :
- des moyens de mesure de la tension (14) et des moyens de mesure de l'intensité (16) en un point de câble ; et,
- des moyens de filtrage (34) aptes à filtrer, à la fréquence prédéterminée, les signaux de mesure de la tension et de l'intensité respectivement délivrées par les moyens de mesure de la tension et de l'intensité pour produire des signaux filtrés de mesure de la tension et de l'intensité.

4. Dispositif selon la revendication 3, **caractérisé en ce que** le moyen de mesure de la tension (14) comporte un transformateur d'isolation (20) à impédance élevée dont le primaire est connecté en série en entrée du câble (10), et **en ce que** le moyen de mesure de l'intensité (16) comporte un transformateur de courant (30) à résistance faible dont le primaire est connecté en série en entrée du câble (10).

5. Dispositif selon l'une quelconque des revendications précédentes, **caractérisé en ce que** la fréquence prédéterminée correspond à la fréquence du signal « C6 » d'un signal électrique de communication entre l'encodeur (3) et la balise (5) selon la norme ERTMS/ETCS.

6. Dispositif selon l'une quelconque des revendications précédentes, **caractérisé en ce que** lesdites valeurs de référence de la phase et du module de l'impédance du câble (10) délimitent des domaines dans le plan complexe de l'impédance du câble de manière à définir une cartographie de calibration (50), et **en ce que** les moyens de détermination de l'état du câble sont aptes à situer la phase et le module mesurés dans un domaine particulier de ladite cartographie et à affecter à l'état du câble un état associé audit domaine particulier.

7. Dispositif selon l'une quelconque des revendications précédentes, **caractérisé en ce que**, lorsque les moyens de détermination de l'état du câble déterminent un état du câble parmi un état en court circuit et un état en circuit ouvert, les moyens de détermination sont aptes à calculer la position le long du câble (10) de l'anomalie associée.

8. Dispositif selon la revendication 6 et la revendication 7 en combinaison, **caractérisé en ce que** la cartographie de calibration (50) comporte une courbe (A, B) associée à un état du câble parmi un état en court circuit et un état en circuit ouvert, une position sur la courbe indiquant la position le long du câble de l'anomalie associée, et **en ce que** les moyens de détermination de l'état du câble sont aptes à positionner la phase et le module mesurés sur la courbe lors de la détection d'une anomalie et à calculer la position le long du câble (10) de ladite anomalie.

9. Dispositif selon l'une quelconque des revendications précédentes, **caractérisé en ce qu'**il comporte un moyen de déconnexion électrique (60) permettant de court-circuiter la sortie de l'encodeur (3) à laquelle est relié le câble de communication (10) en réponse à la détermination que ledit câble est dans un état parmi un état en court circuit et un état en circuit ouvert.

10. Dispositif selon l'une quelconque des revendications précédentes, **caractérisé en ce qu'**il comporte des moyens d'affichage (70) de l'état du câble (10).

11. Dispositif selon l'une quelconque des revendications précédentes, **caractérisé en ce qu'**il comporte des moyens de mémorisation aptes à stocker des données relatives aux états successifs du câble (10), et une interface d'entrée/sortie 80 permettant la communication avec un terminal utilisateur (82) pour le transfert des données.

12. Equipement au sol (1) d'une installation de supervision d'un véhicule ferroviaire, comportant un encodeur (3), une balise (5) disposée sur une voie et un câble de communication (10) reliant l'encodeur et la balise, **caractérisé en ce qu'**il comporte un dispositif de détection d'anomalie (12) selon l'une quelconque des revendications 1 à 11.

13. Equipement selon la revendication 12, **caractérisé en ce que** ledit dispositif de détection d'anomalie (12) est disposé à l'interface entre l'encodeur (3) et le câble de communication (10).

14. Procédé de détection d'une anomalie du type court-circuit ou circuit ouvert le long d'un câble de communication (10) reliant un encodeur (3) et une balise (5) d'un équipement au sol (1) d'une installation de supervision d'un véhicule ferroviaire, mettant en oeuvre un dispositif de détection d'anomalie (12) selon l'une quelconque des revendications 1 à 10, **caractérisé en ce qu'**il comporte les étapes consistant à :
- mesurer, à une fréquence prédéterminée, la phase et le module de l'impédance du câble lors de la transmission d'un signal électrique de communication généré par l'encodeur à destination de la balise ; et,
- comparer la phase et le module mesurés à des valeurs de référence de la phase et du module de l'impédance du câble de manière à déterminer un état du câble parmi un état de fonctionnement normal, un état en court circuit et un état en circuit ouvert.

15. Procédé selon la revendication 14, **caractérisé en ce que**, après avoir déterminé que le câble (10) est dans un état en court-circuit ou en circuit ouvert, il comporte une étape consistant à calculer la position de l'anomalie le long du câble.

## Claims

1. Device for detecting anomalies (12) along a communication cable (10, 10a, 10b, 10c) connecting an encoder (3) and a beacon (5) of a ground equipment in a rail vehicle supervision installation, **characterised in that** it includes:
- means for measuring impedance (14, 16, 34, 42) capable of measuring, at a predetermined frequency, the phase and modulus of the impedance of the cable (10) during the transmission of an electrical communications signal generated by the encoder for reception at the beacon; and,
- means for determining the state of the cable capable of comparing the measured phase and modulus with reference values of the phase and modulus of the impedance of the cable so as to determine a state of the cable among a normal working state, a short-circuit state and an open-circuit state.

2. Device according to claim 1, **characterised in that** the means for measuring the impedance are capable of measuring an instantaneous value of the phase and modulus of the impedance of the cable (10), and **in that** the means for determining the state of the cable are capable of determining an instantaneous state of the cable, so as to detect the occurrence of an anomaly in real time.

3. Device according to claim 1 or claim 2, **characterised in that** the means for measuring impedance include:
- means for measuring the voltage (14) and means for measuring the current (16) at a point of the cable; and,
- filtering means (34) capable of filtering, at the predetermined frequency, the voltage and current measurement signals respectively delivered by the voltage and current measuring means, to produce filtered voltage and current measurement signals.

4. Device according to claim 3, **characterised in that** the voltage measuring means (14) include a high-impedance isolation transformer (20) of which the primary is connected in series at the input of the cable (10), and **in that** the current measuring means (16) include a low-resistance current transformer (30) of which the primary is connected in series at the input of the cable (10).

5. Device according to any one of the preceding claims, **characterised in that** the predetermined frequency corresponds to the "C6" signal frequency of an electrical communications signal between the encoder (3) and the beacon (5) according to the ERTMS/ETCS standard.

6. Device according to any one of the preceding claims, **characterised in that** the said reference values of the impedance phase and modulus of the cable (10) define domains in the complex plane of the impedance of the cable so as to define a calibration map (50), and **in that** the means for determining the state of the cable are capable of locating the measured phase and modulus in a particular domain of the said map and of assigning a state associated with the said particular domain to the state of the cable.

7. Device according to any one of the preceding claims, **characterised in that**, when the means for determining the state of the cable determine a state of the cable among a short-circuit state and an open-circuit state, the determination means are capable of computing the position of the associated anomaly along the cable (10).

8. Device according to claim 6 and claim 7 in combination, **characterised in that** the calibration map (50) includes a curve (A, B) associated with a state of the cable among a short-circuit state and an open-circuit state, a position on the curve indicating the position of the associated anomaly along the cable, and **in that** the means for determining the state of the cable are capable of positioning the measured phase and modulus on the curve upon the detection of an anomaly and of computing the position of the said anomaly along the cable (10).

9. Device according to any one of the preceding claims, **characterised in that** it includes a means for electrical disconnection (60) making it possible to short circuit the output of the encoder (3) to which the communications cable (10) is connected in response to the determination that the said cable is in a state among a short-circuit state and an open-circuit state.

10. Device according to any one of the preceding claims, **characterised in that** it includes means (70) for displaying the state of the cable (10).

11. Device according to any one of the preceding claims, **characterised in that** it includes memory means capable of storing data relating to the successive states of the cable (10), and an input/output interface 80 enabling communication with a user terminal (82) for transferring data.

12. Ground equipment (1) of a rail vehicle supervision installation, including an encoder (3), a beacon (5) arranged on a track and a communication cable (10) connecting the encoder and the beacon, **characterised in that** it includes a device for detecting anomalies (12) according to any one of claims 1 to 11.

13. Equipment according to claim 12, **characterised in that** the said device for detecting anomalies (12) is disposed at the interface between the encoder (3) and the communication cable (10).

14. Method for detecting an anomaly of the short-circuit or open-circuit type along a communication cable (10) connecting an encoder (3) and a beacon (5) of a ground equipment (1) in a rail vehicle supervision installation, putting into effect a device for detecting anomalies (12) according to any one of claims 1 to 10, **characterised in that** it includes the steps of:
- measuring, at a predetermined frequency, the phase and modulus of the impedance of the cable during the transmission of an electrical communications signal generated by the encoder for reception at the beacon; and,
- comparing the measured phase and modulus with reference values of the phase and modulus of the impedance of the cable so as to determine a state of the cable among a normal working state, a short-circuit state and an open-circuit state.

15. Method according to claim 14, **characterised in that**, after determining that the cable (10) is in a short-circuit or open-circuit state, it includes a step of computing the position of the anomaly along the cable.

## Patentansprüche

1. Vorrichtung zur Detektion von Anomalien (12) längs eines Verbindungskabels (10, 10a, 10b, 10c), das einen Kodierer (3) und eine Bake (5) einer Bodengerätschaft einer Überwachungsanlage eines Schienenfahrzeugs miteinander verbindet,
**dadurch gekennzeichnet, dass** sie umfasst:
- Impedanzmesseinrichtungen (14, 16, 34, 42), fähig während der Übertragung eines elektrischen Kommunikationssignals, erzeugt durch den Kodierer und bestimmt für die Bake, mit einer vorher festgelegten Frequenz die Phase und den Modul der Impedanz des Kabels (10) zu messen; und
- Einrichtungen zur Bestimmung des Kabelzustands, fähig Phase und Modul wie gemessen zu vergleichen mit Bezugswerten von Impedanzphase und -modul des Kabels, um einen Zustand des Kabels zwischen einem Normalbetriebszustand, einem Kurzschlussbetriebszustand und einem Leerlaufbetriebszustand zu bestimmen.

2. Vorrichtung nach Anspruch 1, **dadurch gekennzeichnet, dass** die Impedanzmesseinrichtungen fähig sind, einen Momentanwert der Phase und des Moduls der Impedanz des Kabels (10) zu messen, und **dadurch**, dass die Einrichtungen zur Bestimmung des Kabelzustands fähig sind, einen Momentanzustand des Kabels zu bestimmen bzw. festzustellen, um das Auftreten einer Anomalie in Echtzeit zu detektieren.

3. Vorrichtung nach Anspruch 1 oder Anspruch 2, **dadurch gekennzeichnet, dass** die Impedanzmesseinrichtungen umfassen:
- Einrichtungen (14) zur Spannungsmessung und Einrichtungen (16) zur Messung der Stromstärke an einem Punkt des Kabels; und
- Filtereinrichtungen (34), fähig mit der vorher festgelegten Frequenz die Spannungs- und Stromstärken-Messsignale, jeweils geliefert durch die Spannungs- und Stromstärkenmesseinrichtungen, zu filtern, um gefilterte Messsignale der Spannung und der Stromstärke zu erzeugen.

4. Vorrichtung nach Anspruch 3, **dadurch gekennzeichnet, dass** die Spannungsmesseinrichtungen (14) einen Isolationstransformator (20) mit hoher Impedanz umfassen, dessen Primärseite in Serie mit dem Eingang des Kabels (10) verbunden ist, und **dadurch**, dass die Strommesseinrichtungen (16) einen Stromtransformator (30) mit niedrigem Widerstand umfassen, dessen Primärseite in Serie mit dem Eingang des Kabels (10) verbunden ist.

5. Vorrichtung nach einem der vorhergehenden Ansprüche, **dadurch gekennzeichnet, dass** die vorher festgelegte Frequenz der Frequenz des Signals "C6" eines elektrischen Verbindungssignals zwischen dem Kodierer (3) und der Bake (5) gemäß der Norm ERTMS/ETCS entspricht.

6. Vorrichtung nach einem der vorhergehenden Ansprüche, **dadurch gekennzeichnet, dass** die genannten Bezugswerte der Phase und des Moduls der Impedanz des Kabels (10) in der komplexen Impedanzebene Bereiche abgrenzen, um eine Kalibrierungskartografie (50) zu definieren, und **dadurch**, dass die Einrichtungen zur Bestimmung des Kabelzustands fähig sind, Phase und Modul wie gemessen in einen besonderen bzw. speziellen Bereich der genannten Kartografie einzuordnen und dem Zustand des Kabels einem mit dem genannten speziellen Bereich des Kabels verknüpften Zustand zuzuordnen.

7. Vorrichtung nach einem der vorhergehenden Ansprüche, **dadurch gekennzeichnet, dass**
- wenn die Bestimmungseinrichtungen des Kabelzustands einen Kabelzustand zwischen einem Kurzschlusszustand und einem Leerlaufzustand feststellen -, die Bestimmungseinrichtungen fähig sind, die Position der damit verbundenen Anomalie längs des Kabels (10) zu berechnen.

8. Vorrichtung nach Anspruch 6 in Kombination mit Anspruch 7, **dadurch gekennzeichnet, dass** die Kalibrierungskartografie (50) eine mit einem Kabelzustand zwischen einem Kurzschlusszustand und einem Leerlaufzustand verknüpfte Kurve (A, B) umfasst, wobei eine Position auf der Kurve die Position der assoziierten Anomalie längs des Kabels angibt, und **dadurch**, dass die Einrichtungen zur Bestimmung des Kabelzustands fähig sind, die Phase und den Modul, wie gemessen, während der Detektion einer Anomalie auf der Kurve zu positionieren und die Position der genannten Anomalie längs des Kabels (10) zu berechnen.

9. Vorrichtung nach einem der vorhergehenden Ansprüche, **dadurch gekennzeichnet, dass** sie eine elektrische Abschalteinrichtung (60) umfasst, die ermöglicht, den Ausgang des Kodierers (3), an den das Verbindungskabel (10) angeschlossen ist, kurzzuschließen als Reaktion auf die Feststellung, dass sich das genannte Kabel in einem Zustand zwischen einem Kurzschlusszustand und einem Leerlaufzustand befindet.

10. Vorrichtung nach einem der vorhergehenden Ansprüche, **dadurch gekennzeichnet, dass** sie Anzeigeeinrichtungen (70) des Zustands des Kabels (10) umfassen.

11. Vorrichtung nach einem der vorhergehenden Ansprüche, **dadurch gekennzeichnet, dass** sie Speichereinrichtungen umfassen, fähig zur Speicherung der die sukzessiven Zustände des Kabels (10) betreffenden Daten, sowie eine Eingangs-/Ausgangsschnittstelle (80), die die Kommunikation mit einem Benutzer-Terminal (82) für den Transfer der Daten ermöglicht.

12. Bodengerätschaft (1) einer Überwachungsanlage eines Schienenfahrzeugs, umfassend einen Kodierer (3), eine Bake (5), angeordnet auf einem Gleis, und ein den Kodierer mit der Bake verbindendes Verbindungskabel (10), **dadurch gekennzeichnet, dass** es eine Anomaliendetektionsvorrichtung (12) nach einem der Ansprüche 1 bis 11 umfasst.

13. Gerätschaft nach Anspruch 12, **dadurch gekennzeichnet, dass** die genannte Anomaliendetektionsvorrichtung (12) an der Schnittstelle zwischen dem Kodierer (3) und dem Verbindungskabel (10) angeordnet ist.

14. Verfahren zur Detektion einer Anomalie des Typs Kurzschluss oder Leerlauf längs eines einen Kodierer (3) und eine Bake (5) einer Bodengerätschaft (1) einer Überwachungsanlage eines Schienenfahrzeugs verbindenden Verbindungskabels (10), das eine Anomaliendetektionsvorrichtung (12) nach einem der Ansprüche 1 bis 10 benutzt, **dadurch gekennzeichnet, dass** es die folgenden Schritte umfasst:
- Messen - mit einer vorher festgelegten Frequenz - der Phase und des Moduls der Impedanz des Kabels während der Übertragung eines durch den Kodierer erzeugten und für die Bake bestimmten elektrischen Kommunikationssignals; und
- Vergleichen der Phase und des Moduls wie gemessen mit Bezugswerten der Phase und des Moduls der Impedanz des Kabels, um einen Kabelzustand zwischen einem Normalbetriebszustand, einem Kurzschlusszustand und einem Leerlaufzustand zu bestimmen.

15. Verfahren nach Anspruch 14, **dadurch gekennzeichnet, dass** - nachdem bestimmt bzw. festgestellt wurde, dass sich das Kabel (10) in einem Kurzschluss- oder Leerlaufzustand befindet - es einen darin bestehenden Schritt umfasst, die Position der Anomalie längs des Kabels zu berechnen.
